# EUROPEAN PATENT APPLICATION

(11) **EP 4 783 803 A1**
(43) Date of publication of application: **29.07.2026**
(21) Application number: 24868519.0
(22) Date of filing: 29.08.2024
(51) Int. Cl.: H10K 59/80, H10K 59/122, H10K 50/81, H10K 50/82, H10K 50/15, H10K 50/16, H10K 59/40, H10K 59/38, H10K 59/12, H10K 71/00

(54) **DISPLAY DEVICE AND MANUFACTURING METHOD THEREFOR**

(30) Priority: 19.09.2023 KR 20230124883
(71) Applicant: Samsung Display Co., Ltd., Yongin-si, Gyeonggi-do 17113 (KR)
(72) Inventor: LEE, Jung-Woo, Yongin-Si Gyeonggi-do 17113 (KR); KIM, Wooyoung, Yongin-Si Gyeonggi-do 17113 (KR)
(74) Representative: Marks & Clerk LLP
(86) International application number: PCT/KR2024/012938
(87) International publication number: WO 2025/063540

(57) **Abstract**

An embodiment of the inventive concept provides a display device includes a display panel, and the display panel includes a base substrate, a light-emitting element including a light-emitting layer disposed on the base substrate, an inorganic deposition layer disposed on the light-emitting element, and an encapsulation layer disposed on the inorganic deposition layer, wherein the inorganic deposition layer includes a first portion having a first upper surface inclined at a first angle with respect to an upper surface of the base substrate and a second portion having a second upper surface substantially parallel to the upper surface of the base substrate, a first thickness of the first portion is greater than a second thickness of the second portion. Accordingly, external light reflection may be reduced, and a layer uniformity may be improved, and thus the display device may have improved display efficiency.

## Description

### [Technical Field]

The present disclosure herein relates to a display device and a method of manufacturing the same, and more particularly, to a display device having improved display efficiency and a method of manufacturing the same.

### [Background Art]

Various display devices used in multimedia apparatuses such as televisions, mobile phones, tablet computers, and game consoles have been developed. A display device may include various optical functional layers so as to provide a color image of excellent quality to a user.

Meanwhile, research on a thin display device has been recently conducted to achieve display devices in various forms such as a display device having a curved surface, a rollable display device, or a foldable display device. A thin display device may be achieved by reducing the number of optical functional layers and including an optical functional layer having various functions.

### [Disclosure]

### [Technical Problem]

The present disclosure provides a display device having an improved optical property due to reduced external light reflection and improved display efficiency, and a method of manufacturing the same.

### [Technical Solution]

An embodiment of the inventive concept provides a display device including a display panel. The display panel includes a base substrate, a light-emitting element disposed on the base substrate and including a light-emitting layer, an inorganic deposition layer disposed on the light-emitting element, and an encapsulation layer disposed on the inorganic deposition layer. The inorganic deposition layer includes a first portion including a first upper surface having a first angle with respect to an upper surface of the base substrate, and a second portion including a second upper surface substantially parallel to the upper surface of the base substrate, and a first thickness of the first portion is greater than a second thickness of the second portion.

In an embodiment, the first angle may be about 60 degrees to about 90 degrees.

In an embodiment, a surface roughness of the first upper surface may be lower than a surface roughness of the second upper surface.

In an embodiment, an irregular pattern may be defined on the second upper surface.

In an embodiment, the display panel may further include a pixel-defining film disposed on the base substrate and having an opening defined therein, and the light-emitting layer may be disposed in the opening.

In an embodiment, the pixel-defining film may include a side surface defining the opening, and a second angle formed by the side surface of the pixel-defining film with respect to the upper surface of the base substrate may be substantially the same as the first angle.

In an embodiment, the inorganic deposition layer may include an inorganic material having a refractive index of about 1.0 or more and a light absorption coefficient of about 0.5 or more.

In an embodiment, the inorganic deposition layer may include at least one selected from the group consisting of bismuth (Bi) and ytterbium (Yb).

In an embodiment, a difference between the first thickness and the second thickness may be about 5 Å to about 50 Å.

In an embodiment, the first thickness may be about 50 Å to about 200 Å.

In an embodiment, the second thickness may be about 40 Å or more and less than about 100 Å.

In an embodiment, the encapsulation layer may be entirely in contact with the first upper surface and the second upper surface.

In an embodiment, the light-emitting element may further include a first electrode disposed on the base substrate, a second electrode disposed to be spaced apart from the first electrode with the light-emitting layer therebetween, a hole transport region disposed between the first electrode and the light-emitting layer, an electron transport region disposed between the second electrode and the light-emitting layer, and a capping layer disposed on the second electrode, the inorganic deposition layer being directly disposed on the capping layer.

In an embodiment, the display device may further include a light control layer disposed on the display panel and including a dye or a pigment, and a sensor layer disposed between the display panel and the light control layer.

In an embodiment of the inventive concept, a display device includes a display panel, and a light control layer disposed on the display panel and including a dye or a pigment. The display panel includes a base substrate, a light-emitting element disposed on the base substrate and including a light-emitting layer, an inorganic deposition layer disposed on the light-emitting element and including a partition portion and a flat portion adjacent to the partition portion, and an encapsulation layer being entirely in contact with a first upper surface of the partition portion and a second upper surface of the flat portion. The first upper surface has a first angle with respect to an upper surface of the base substrate, and the second upper surface is substantially parallel to the upper surface of the base substrate. A surface roughness of the first upper surface is lower than a surface roughness of the second upper surface.

In an embodiment of the inventive concept, a method of manufacturing a display device includes providing a base substrate and a light-emitting element including a light-emitting layer disposed on the base substrate, forming, on the light-emitting element, an inorganic deposition layer including an inorganic material, and forming an encapsulation layer on the inorganic deposition layer. The forming of the inorganic deposition layer may include forming a preliminary inorganic deposition layer including a first preliminary portion which includes a first preliminary upper surface having a first angle with respect to an upper surface of the base substrate, and a second preliminary portion which includes a second preliminary upper surface substantially parallel to the upper surface of the base substrate, and forming an irregular pattern by etching at least a portion of the second preliminary upper surface.

In an embodiment, the first angle may be about 60 degrees to about 90 degrees.

In an embodiment, the forming of the preliminary inorganic deposition layer may include performing a thermal evaporation process.

In an embodiment, the forming of the irregular pattern may include performing any one among a wet etching process, a dry etching process, and an ion milling process.

In an embodiment, a thickness of the first preliminary portion and a thickness of the second preliminary portion may be substantially the same.

### [Advantageous Effects]

According to an embodiment of the inventive concept, a display device includes, in an inorganic deposition layer, a portion having a non-uniform thickness. Accordingly, a display device including a light-emitting element may have improved light efficiency and reduced external light reflection.

### [Description of Drawings]

FIG. 1 is a perspective view of a display device according to an embodiment of the inventive concept;
FIG. 2 is an exploded perspective view of a display device according to an embodiment of the inventive concept;
FIG. 3 is a plan view of a display device according to an embodiment;
FIG. 4 is a cross-sectional view of a display device according to an embodiment;
FIG. 5 is an enlarged cross-sectional view of a portion of a display device according to an embodiment of the inventive concept;
FIG. 6A and FIG. 6B are flowcharts illustrating a method of manufacturing a display device according to an embodiment of the inventive concept; and
FIG. 7A and FIG. 7B are drawings sequentially illustrating some operations of a method of manufacturing a display device according to an embodiment of the inventive concept.

### [Mode for Invention]

Hereinafter, embodiments of the inventive concept will be described with reference to the accompanying drawings.

In this specification, when an element (or a region, a layer, a portion, etc.) is referred to as being "on", "connected to" or "coupled to" another element, it may be directly on, connected or coupled to the other element or intervening elements may be disposed therebetween.

Like numerals or symbols refer to like elements throughout. In addition, in the drawings, thicknesses, ratios, and dimensions of elements are exaggerated for effective description of the technical contents. The term "and/or" includes all of one or more combinations that the associated elements may define.

Although the terms first, second, etc. may be used to describe various elements, these elements should not be limited by these terms. These terms are only used to distinguish one element from another element. For example, a first element may be referred to as a second element, and similarly, a second element may also be referred to as a first element without departing from the scope of the inventive concept. The singular forms include the plural forms as well, unless the context clearly indicates otherwise.

In addition, terms such as "below", "lower", "above", "upper" are used to describe the relationships of the elements illustrated in the drawings. The terms are relative concepts and are described on the basis of the directions indicated in the drawings.

It will be understood that the terms such as "include" or "have", when used herein, are intended to specify the presence of stated features, integers, steps, operations, elements, components, or combinations thereof, but do not preclude the presence or addition of one or more other features, integers, steps, operations, elements, components, or combinations thereof.

As used herein, "directly disposed" may mean that there is no intervening layer, film, region, plate, etc. added between a portion of a layer, film, region, plate, etc. and another portion thereof. For example, "directly disposed" may mean that two layers or two members are disposed without using an additional member such as an adhesive member therebetween.

Unless otherwise defined, all terms (including technical and scientific terms) used herein have the same meaning as commonly understood by a person skill in the art. In addition, terms such as those defined in commonly used dictionaries should be interpreted as having a meaning that is consistent with their meaning in the context of the relevant art and will not be interpreted in an overly idealized or overly formal sense unless expressly so defined herein.

Hereinafter, a display device according to an embodiment of the inventive concept will be described with reference to the accompanying drawings.

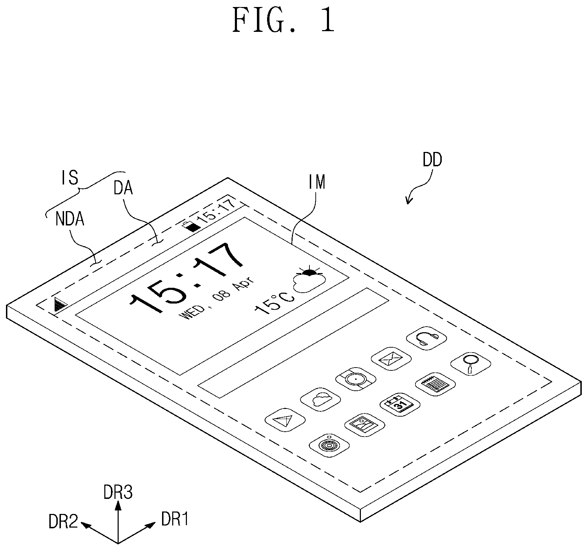

FIG. 1 is a perspective view of a display device according to an embodiment of the inventive concept. FIG. 1 illustrates a portable electronic apparatus as an example of a display device DD. However, the display device DD may be used in a large-sized electronic apparatus such as a television, a monitor, or a billboard, as well as a small and medium-sized electronic apparatus such as a personal computer, a laptop, a personal digital assistant, a car navigation unit, a game console, a smartphone, a tablet PC, and a camera. In addition, these are simply presented as examples, and thus the display device DD may also be employed in other electronic apparatuses without departing from the scope of the inventive concept.

The display device DD may have a hexahedral form having a thickness in a third direction DR3 on a plane defined by a first direction DR1 and a second direction DR2 crossing each other. However, this is illustrated as an example, and the display device DD may have various forms, and an embodiment of the inventive concept is not limited thereto.

In an embodiment, an upper surface (or a front surface) and a lower surface (or a rear surface) of each member are defined on the basis of a direction in which an image IM is displayed. The upper surface and the lower surface may be opposed to each other in the third direction DR3, and a normal direction of each of the upper surface and the lower surface may be parallel to the third direction DR3.

Meanwhile, directions indicated by the first to third directions DR1, DR2, and DR3 may have relative concepts, and may thus be changed into other directions.

The display device DD may display the image IM through a display surface IS. The display surface IS includes a display region DA where the image IM is displayed, and a non-display region NDA adjacent to the display region DA. The non-display region NDA is a region where the image is not displayed. The image IM may be a dynamic image or a still image. FIG. 1 illustrates a plurality of application icons, a clock, and the like as examples of the image IM.

The display region DA may have a quadrangular shape. The non-display region NDA may surround the display region DA. However, this is an example, and an embodiment of the inventive concept is not limited thereto. Thus, a shape of the display region DA and a shape of the non-display region NDA may be relatively designed. In addition, the non-display region NDA may not exist in a front surface of the display device DD.

The display device DD may be flexible. This may imply a bendable property, and the display device DD may be a device including any one from among a structure which is completely foldable to a structure which is bendable to a level of several nanometers. For example, the display device DD may be a curved display device or a foldable display device. However, an embodiment of the inventive concept is not limited thereto, and the display device DD may be rigid.

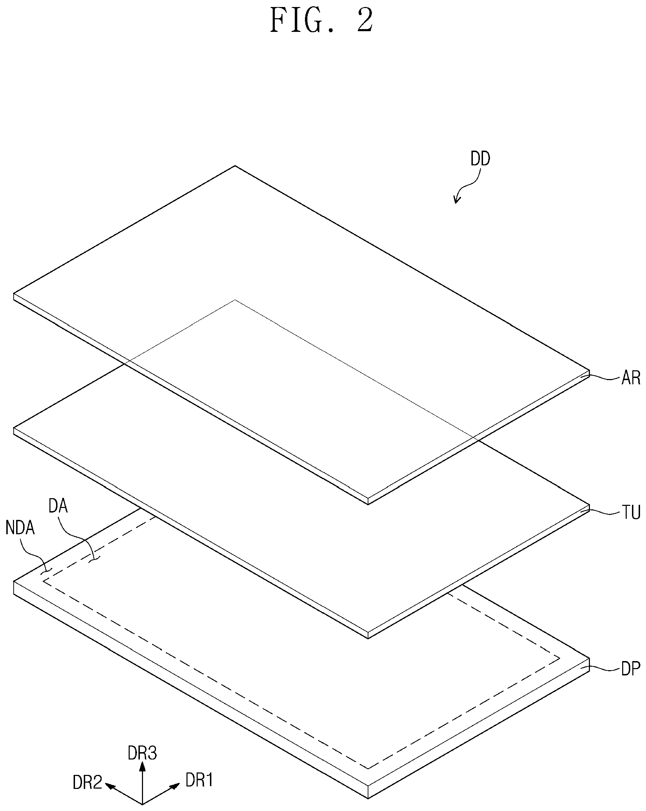

FIG. 2 is an exploded perspective view of a display device according to an embodiment of the inventive concept. Referring to FIG. 2, a display device DD according to an embodiment may include a display panel DP, a sensor layer TU, and a light control layer AR, which are sequentially stacked along a third direction DR3.

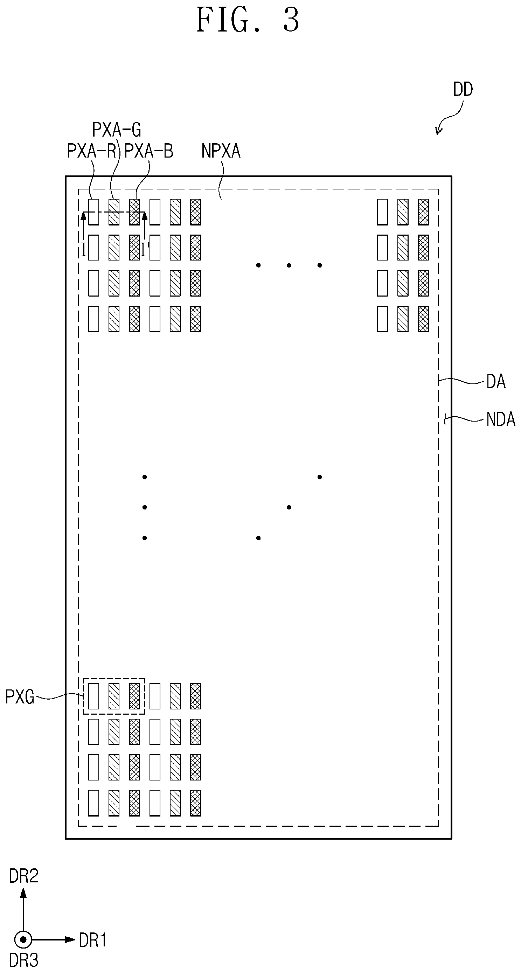

The display panel DP may include a plurality of pixels in a region corresponding to the display device DD. The plurality of pixels may correspond to a plurality of pixel regions PXA-R, PXA-B, and PXA-G (see FIG. 3). The plurality of pixels may display light in response to an electrical signal. The plurality of pixels may make it possible for a display region DA to display the image IM generated by light.

The display panel DP according to an embodiment may be a self-luminous display panel. For example, the display panel DP may be a micro-LED display panel, a nano-LED display panel, an organic light-emitting display panel, or a quantum dot light-emitting display panel. However, these are merely examples, and an embodiment of the inventive concept is not limited thereto as long as the display panel DP is a self-luminous display panel.

A light-emitting layer of the organic light-emitting display panel may include an organic light-emitting material. A light-emitting layer of the quantum dot light-emitting display panel may include quantum dots and/or quantum rods, etc. The micro-LED display panel may include a micro-light-emitting diode element that is a ultrasmall light-emitting element, and the nano-LED display panel may include a nano-light-emitting diode element. Hereinafter, the display panel DP will be described as an organic light-emitting display panel.

The light control layer AR may be disposed on the display panel DP. The light control layer AR may be an anti-reflective layer which reduces a reflectance for external light incident from the outside. The light control layer AR may be a layer which selectively transmits light emitted from the display panel DP. The light control layer AR may not include a polarizing layer. Accordingly, light passing through the light control layer AR and incident onto the display panel DP and the sensor layer TU may be unpolarized light. The display panel DP and the sensor layer TU may receive unpolarized light from above the light control layer AR.

The sensor layer TU may be disposed between the display panel DP and the light control layer AR. The sensor layer TU may acquire, by an external input, information for generating an image on the display panel DP. The external input may be a user's input. The user's input may include external inputs in various forms such as a body part of a user, light, heat, a pen, or pressure.

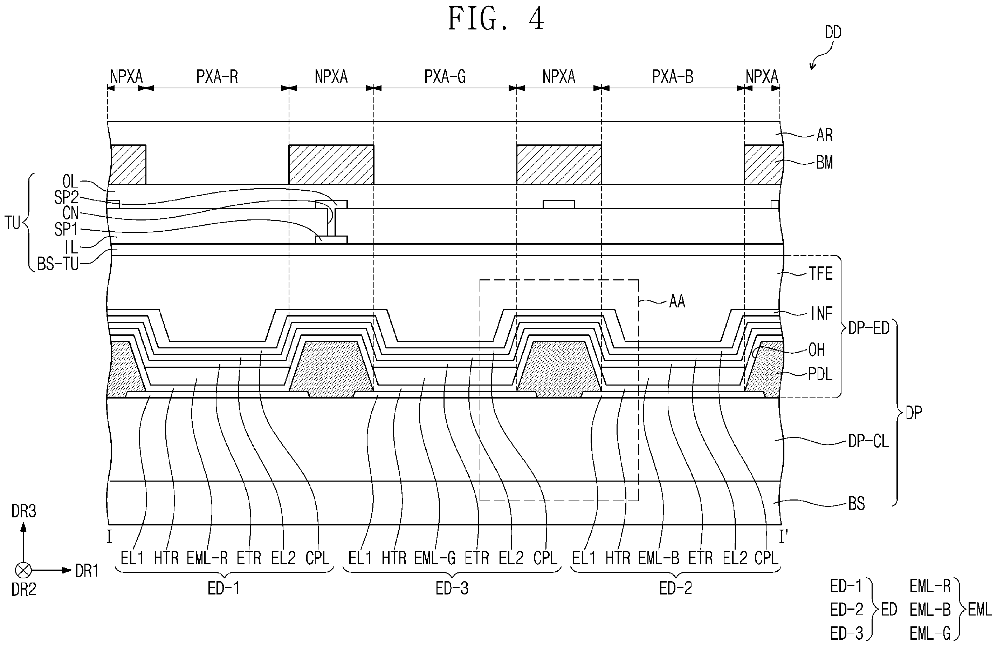

FIG. 3 is a plan view of a display device according to an embodiment. FIG. 4 is a cross-sectional view of a display device according to an embodiment. FIG. 4 is a cross-sectional view of a portion, of a display device according to an embodiment, taken along a line I-I' of FIG. 3.

Referring to FIG. 3 and FIG. 4, a display device DD according to an embodiment includes a display panel DP, a sensor layer TU disposed on the display panel DP, and a light control layer AR disposed on the sensor layer TU, which are sequentially stacked.

The display panel DP may include a base substrate BS, a circuit layer DP-CL, and a display element layer DP-ED, which are sequentially stacked. The display element layer DP-ED may include a pixel-defining film PDL, light-emitting elements ED disposed in pixel openings OH defined in the pixel-defining film PDL, and an encapsulation layer TFE disposed on the light-emitting elements ED.

The base substrate BS may be rigid or flexible. The base substrate BS may be a polymer substrate, a plastic substrate, a glass substrate, a metal substrate, a composite material substrate, or the like. The base substrate BS may have a multi-layered structure as well as a single-layered structure. The base substrate BS may include a synthetic resin film, and the base substrate BS may have a multi-layered structure including a plurality of synthetic resin film layers. The synthetic resin film may include a polyimide-based, an acrylate-based, a vinyl-based, an epoxy-based, a urethane-based, a cellulose-based, a perylene-based material, etc., but a material of the synthetic resin film is not limited thereto.

The circuit layer DP-CL may be disposed on the base substrate BS. The circuit layer DP-CL may include an insulating layer, a semiconductor pattern, a conductive pattern, a signal line, and the like. The circuit layer DP-CL may include a plurality of transistors (not illustrated) formed of a semiconductor pattern, a conductive pattern, a signal line, and the like. Each of the transistors (not illustrated) may include a control electrode, an input electrode, and an output electrode. For example, the circuit layer DP-CL may include a driving transistor and a switching transistor for driving a light-emitting element ED.

The display element layer DP-ED may be disposed on the circuit layer DP-CL. The display element layer DP-ED may include the pixel-defining film PDL, the light-emitting element ED, and the encapsulation layer TFE.

The light-emitting element ED may include a plurality of light-emitting elements ED-1, ED-2, and ED-3. The light-emitting elements ED-1, ED-2, and ED-3 may each include a first electrode EL1, a hole transport region HTR, an electron transport region ETR, a second electrode EL2, and a capping layer CPL, and may respectively include light-emitting layers EML-R, EML-B, and EML-G. A first light-emitting element ED-1 may include a first light-emitting layer EML-R overlapping a first pixel region PXA-R. A second light-emitting element ED-2 may include a second light-emitting layer EML-B overlapping a second pixel region PXA-B. A third light-emitting element ED-3 may include a third light-emitting layer EML-G overlapping a third pixel region PXA-G.

The pixel-defining film PDL may be disposed on the circuit layer DP-CL. Predetermined pixel openings OH may be defined in the pixel-defining film PDL. The pixel openings OH defined in the pixel-defining film PDL may respectively correspond to a plurality of pixel regions PXA-R, PXA-B, and PXA-G. A light-shielding region NPXA may be a region between neighboring pixel regions PXA-R, PXA-B, and PXA-G and may be a region corresponding to the pixel-defining film PDL.

The pixel-defining film PDL may have a light-absorbing property, and for example, the pixel-defining film PDL may have a black color. The pixel-defining film PDL may include a black coloring agent. The black coloring agent may include a black dye or a black pigment. The black coloring agent may include carbon black, metal such as chromium, or oxides thereof. The pixel-defining film PDL may correspond to a light-shielding pattern having a light-shielding property.

The pixel-defining film PDL may include an organic resin or an inorganic material. For example, the pixel-defining film PDL may be formed while including a polyacrylate-based resin, a polyimide-based resin, or silicon nitride (SiNx), silicon oxide (SiOx), silicon oxynitride (SiOxNy), etc.

FIG. 4 illustrates an embodiment in which the respective light-emitting layers EML-R, EML-B, and EML-G of the light-emitting elements ED-1, ED-2, and ED-3 are disposed in the pixel openings OH defined in the pixel-defining film PDL, and the hole transport region HTR, the electron transport region ETR, the second electrode EL2, and the capping layer CPL are provided as common layers in all of the light-emitting elements ED-1, ED-2, and ED-3. However, an embodiment of the inventive concept is not limited thereto, and in an embodiment, unlike what is illustrated in FIG. 4, the hole transport region HTR, the electron transport region ETR, the second electrode EL2, the capping layer CPL, etc., may be provided by being patterned in a pixel opening OH defined in the pixel-defining film PDL. In an embodiment, at least one among the hole transport region HTR, the electron transport region ETR, the second electrode EL2, the capping layer CPL, and the light-emitting layers EML-R, EML-B or EML-G of the light-emitting elements ED-1, ED-2 or ED-3 may be provided by being patterned through an inkjet printing method.

In the light-emitting element ED, the first electrode EL1 may be disposed on the circuit layer DP-CL. The first electrode EL1 may be an anode or a cathode. In addition, the first electrode EL1 may be a pixel electrode. The first electrode EL1 may be a transmissive electrode, a transflective electrode, or a reflective electrode.

The hole transport region HTR may be disposed between the first electrode EL1 and a light-emitting layer EML. The hole transport region HTR may include at least one of a hole injection layer, a hole transport layer, and an electron blocking layer. The hole transport region HTR may be disposed as a common layer so as to entirely overlap the pixel regions PXA-R, PXA-B, and PXA-G and the pixel-defining film PDL separating the pixel regions PXA-R, PXA-B, and PXA-G. However, an embodiment of the inventive concept is not limited thereto, and the hole transport region HTR may be provided through patterning so that patterned hole transport regions are separately disposed to respectively correspond to the pixel regions PXA-R, PXA-B, and PXA-G. The light-emitting layer EML may be disposed on the first electrode EL1. The light-emitting layer EML may include a plurality of light-emitting layers EML-R, EML-B, and EML-G. The first light-emitting layer EML-R may overlap the first pixel region PXA-R and emit first light. The second light-emitting layer EML-B may overlap the second pixel region PXA-B and emit second light. The third light-emitting layer EML-G may overlap the third pixel region PXA-G and emit third light. In the light-emitting elements ED-1, ED-2, and ED-3 according to an embodiment, the first to third light may be in substantially different wavelength ranges. For example, the first light may be red light in a wavelength range of about 625 nm to about 675 nm. For example, the second light may be blue light in a wavelength range of about 410 nm to about 480 nm. The third light may be green light in a wavelength range of about 500 nm to about 570 nm.

The electron transport region ETR may be disposed between the light-emitting layer EML and the second electrode EL2. The electron transport region ETR may include at least one of an electron injection layer, an electron transport layer, and a hole blocking layer. The electron transport region ETR may be disposed as a common layer so as to entirely overlap the pixel regions PXA-R, PXA-B, and PXA-G and the pixel-defining film PDL separating the pixel regions PXA-R, PXA-B, and PXA-G. However, an embodiment of the inventive concept is not limited thereto, and the electron transport region ETR may be provided through patterning so that patterned electron transport regions are separately disposed to respectively correspond to the pixel regions PXA-R, PXA-B, and PXA-G.

The second electrode EL2 is provided on the electron transport region ETR. The second electrode EL2 may be a common electrode. The second electrode EL2 may be a cathode or an anode, but an embodiment of the inventive concept is not limited thereto. For example, when the first electrode EL1 is an anode, the second electrode EL2 may be a cathode, and when the first electrode EL1 is a cathode, the second electrode EL2 may be an anode. The second electrode EL2 may be a transmissive electrode, a transflective electrode, or a reflective electrode.

The capping layer CPL may be further disposed on the second electrode EL2. The capping layer CPL may include a plurality of layers or a single layer. In an embodiment, the capping layer CPL may be an organic layer or an inorganic layer. For example, when the capping layer CPL includes an inorganic material, the inorganic material may include an alkali metal compound such as LiF, an alkaline earth metal compound such as MgF₂, SiON, SiN_{X}, SiOy, etc. For example, when the capping layer CPL includes an organic material, the organic material may include α-NPD, NPB, TPD, m-MTDATA, Alq₃, CuPc, N4,N4,N4',N4'-tetra (biphenyl-4-yl) biphenyl-4,4'-diamine (TPD15), 4,4',4"-tris (carbazol-9-yl) triphenylamine (TCTA), etc., or include an epoxy resin, or acrylate such as methacrylate. However, an embodiment of the inventive concept is not limited thereto.

Meanwhile, a refractive index of the capping layer CPL may be about 1.6 or more. Specifically, a refractive index of the capping layer CPL with respect to light in a wavelength range of about 550 nm to about 660 nm may be about 1.6 or more.

The encapsulation layer TFE may be disposed on the pixel-defining film PDL and cover the light-emitting element ED. The encapsulation layer TFE may fill a portion of the pixel opening OH and may be disposed on the capping layer CPL. In addition, as illustrated in FIG. 4, when the light-emitting element ED includes an inorganic deposition layer INF, the encapsulation layer TFE may be disposed on the inorganic deposition layer INF. The encapsulation layer TFE may serve as protecting the light-emitting element ED from moisture and/or oxygen and protecting the light-emitting element ED from foreign substances such as dust particles.

FIG. 4 illustrates the encapsulation layer TFE as a single layer, but the encapsulation layer TFE may include at least one organic film or inorganic film, or include both of an organic film and an inorganic film. The encapsulation layer TFE may have a thinfilm encapsulation layer structure including at least one organic film and at least one inorganic film. For example, the encapsulation layer TFE may have a structure in which an organic film and an inorganic film are alternately and repeatedly stacked, or a structure in which an inorganic film, an organic film, and an inorganic film are sequentially stacked.

The inorganic film included in the encapsulation layer TFE may include, for example, a silicon nitride layer, a silicon oxynitride layer, a silicon oxide layer, a titanium oxide layer, an aluminium oxide layer, or the like, but an embodiment of the inventive concept is not limited thereto. The organic film included in the encapsulation layer TFE may include an acrylate-based organic film, but an embodiment of the inventive concept is not limited thereto.

The display device DD may include the light-shielding region NPXA and the pixel regions PXA-R, PXA-B, and PXA-G. The pixel regions PXA-R, PXA-B, and PXA-G may be regions respectively emitting light generated from the light-emitting elements ED-1, ED-2, and ED-3. The pixel regions PXA-R, PXA-B, and PXA-G may be spaced apart from each other on a plane.

The pixel regions PXA-R, PXA-B, and PXA-G may each be separated by the pixel-defining film PDL. The light-shielding region NPXA may be a region between neighboring pixel regions PXA-R, PXA-B, and PXA-G and may be a region corresponding to the pixel-defining film PDL. Meanwhile, in this specification, each of the pixel regions PXA-R, PXA-B, and PXA-G may correspond to a pixel. The pixel-defining film PDL may separate the light-emitting elements ED-1, ED-2, and ED-3. The respective light-emitting layers EML-R, EML-B, and EML-G of the light-emitting elements ED-1, ED-2, and ED-3 may be separately disposed in the pixel openings OH defined in the pixel-defining film PDL.

The pixel regions PXA-R, PXA-B, and PXA-G may be divided into a plurality of groups according to a color of light generated from the light-emitting elements ED-1, ED-2, and ED-3. In the display device DD illustrated in FIG. 3 and FIG. 4, three pixel regions PXA-R, PXA-B, and PXA-G respectively emitting red light, blue light, and green light are illustrated as an example. For example, the display device DD according to an embodiment may include the first pixel region PXA-R, the second pixel region PXA-B, and the third pixel region PXA-G, which are distinguished from each other. In an embodiment, the first pixel region PXA-R may be referred to as a red pixel region, the second pixel region PXA-B may be referred to as a blue pixel region, and the third pixel region PXA-G may be referred to as a green pixel region. In the display device DD according to an embodiment, one first pixel region PXA-R, one second pixel region PXA-B, and one third pixel region PXA-G may be grouped and referred to as a unit pixel group PXG. Although not illustrated, at least one of the first pixel region PXA-R, the second pixel region PXA-B, and the third pixel region PXA-G, included in the unit pixel group PXG, may be provided in plurality. For example, two third pixel regions PXA-G, one first pixel region PXA-R, and one second pixel region PXA-B may be included in the unit pixel group PXG.

In the display device DD according to an embodiment, the plurality of light-emitting elements ED-1, ED-2, and ED-3 may emit light in different wavelength ranges. For example, the display device DD according to an embodiment may include the first light-emitting element ED-1 emitting red light, the second light-emitting element ED-2 emitting blue light, and the third light-emitting element ED-3 emitting green light. That is, the red pixel region PXA-R, the blue pixel region PXA-B, and the green pixel region PXA-G of the display device DD may respectively correspond to the first light-emitting element ED-1, the second light-emitting element ED-2, and the third light-emitting element ED-3.

However, an embodiment of the inventive concept is not limited thereto, and the first to third light-emitting elements ED-1, ED-2, and ED-3 may emit light in the same wavelength range, or at least one thereof may emit light in a wavelength range different from the others. For example, all of the first to third light-emitting elements ED-1, ED-2, and ED-3 may emit blue light.

In the display device DD according to an embodiment, the pixel regions PXA-R, PXA-B, and PXA-G may be arranged in a stripe shape. Referring to FIG. 3, a plurality of red pixel regions PXA-R, a plurality of blue pixel regions PXA-B, and a plurality of green pixel regions PXA-G may each be arranged along a second direction DR2. In addition, the pixel regions may be arranged such that the red pixel region PXA-R, the green pixel region PXA-G, and the blue pixel region PXA-B may be alternately and repeatedly arranged in this order along a first direction DR1.

FIG. 3 and FIG. 4 illustrates that all the pixel regions PXA-R, PXA-B, and PXA-G have similar areas, but an embodiment of the inventive concept is not limited thereto. Thus, areas of the pixel regions PXA-R, PXA-B, and PXA-G may vary depending on a wavelength range of the emitted light. Meanwhile, the areas of the pixel regions PXA-R, PXA-B, and PXA-G may be areas viewed on a plane defined by the first direction DR1 and the second direction DR2.

Meanwhile, an arrangement of the pixel regions PXA-R, PXA-B, and PXA-G is not limited to that illustrated in FIG. 3, and an order in which the red pixel region PXA-R, the blue pixel region PXA-B, and the green pixel region PXA-G are arranged may be provided in various combinations according to the characteristics of display quality required for the display device DD. For example, the pixel regions PXA-R, PXA-B, and PXA-G may be arranged in a Pen-TileTM shape or a Diamond PixelTM shape.

In addition, the areas of the pixel regions PXA-R, PXA-B, and PXA-G may be different from each other. For example, in an embodiment, an area of the green pixel region PXA-G may be smaller than an area of the blue pixel region PXA-B, but an embodiment of the inventive concept is not limited thereto.

Referring to FIG. 4, the display panel DP according to an embodiment includes the inorganic deposition layer INF disposed on the light-emitting elements ED-1, ED-2, and ED-3.

The inorganic deposition layer INF may be disposed on the capping layer CPL. The inorganic deposition layer INF may be directly disposed on the capping layer CPL. The inorganic deposition layer INF may be a layer for preventing external light from being reflected by the second electrode EL2 of the light-emitting elements ED-1, ED-2, and ED-3. More specifically, destructive interference may occur between light reflected at a surface of the inorganic deposition layer INF and light reflected at the second electrode EL2, and thus the amount of external light reflected at a surface of the second electrode EL2 may be reduced. Thicknesses of the inorganic deposition layer INF and the capping layer CPL may be adjusted so that destructive interference may occur between light reflected at a surface of the inorganic deposition layer INF and light reflected at the second electrode EL2.

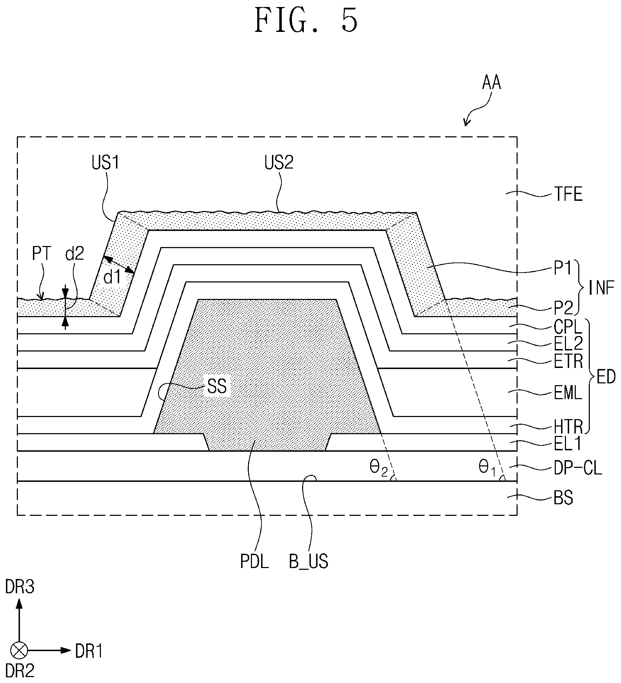

The inorganic deposition layer INF may include an inorganic material having a refractive index of about 1.0 or more and a light absorption coefficient of about 0.5 or more. With respect to a visible light wavelength range of about 380 nm to about 780 nm, the inorganic material included in the inorganic deposition layer INF may have a refractive index of about 1.0 or more and a light absorption coefficient of about 0.5 or more. The inorganic deposition layer INF may be formed through a thermal evaporation process and include an inorganic material having a melting point of about 1000°C or less. The inorganic deposition layer INF may include, for example, at least one selected from the group consisting of bismuth (Bi) and ytterbium (Yb). A material forming the inorganic deposition layer INF may be composed of bismuth (Bi) or ytterbium (Yb), or may be a YbₓBi_{y}-mixed deposition material. The encapsulation layer TFE may be directly disposed on at least a portion of the inorganic deposition layer INF. Detailed description regarding the inorganic deposition layer INF will be made in the description to be made with reference to FIG. 5.

In the display device DD according to an embodiment, the light control layer AR may be disposed on the display panel DP. The light control layer AR may absorb portion of light emitted from the display panel DP and transmit portion of the light, thereby improving color gamut. As used herein, the term "color gamut" refers to a range of colors that are displayable by a display device. For example, color gamut may be improved by selective absorption of light in a specific wavelength range.

The light control layer AR may entirely overlap the display element layer DP-ED. The light control layer AR may entirely overlap each of the first light-emitting element ED-1, the second light-emitting element ED-2, and the third light-emitting element ED-3. The light control layer AR may cover a front surface of the display panel DP and protect the display panel DP.

The light control layer AR may have a high light absorption rate in a specific wavelength range. The light control layer AR may include a first colorant having a high light absorption rate in a specific wavelength range. The first colorant may have a high light absorption rate in a specific wavelength range. The first colorant may have a high light absorption rate in at least one wavelength range. The first colorant may be a material which absorbs light having a maximum absorption wavelength in a wavelength range except a wavelength range of each of the first light, the second light, and the third light. In an embodiment, the first colorant may be a material which absorbs light in a wavelength range of about 490 nm to about 505 nm and light in a wavelength range of about 585 nm to about 600 nm, and transmits the remaining light. The first colorant may have a maximum absorption wavelength in a wavelength range of about 490 nm to about 505 nm and in a wavelength range of about 585 nm to about 600 nm. The first colorant included in the light control layer AR may absorb light in a specific wavelength range and transmit light in the remaining wavelength range, thereby preventing external light reflection and adjusting a color tone of light emitted from the display panel DP.

The first colorant may include at least one of a dye and a pigment. For example, the first colorant included in the light control layer AR may include at least one selected from the group consisting of an anthraquinone-based compound, a phthalocyaninebased compound, an azo-based compound, a perylene-based compound, a xanthenebased compound, a diimmonium-based compound, a dipyrromethene-based compound, a tetraazaporphyrin-based compound, a porphyrin-based compound, a squarylium-based compound, an oxazine-based compound, a triarylmethane-based compound, and a cyanine-based compound. For example, the light control layer AR may include any one among a tetraazaporphyrin-based compound, a cyanine-based compound, a squarylium-based compound, and an oxazine-based compound, or a combination thereof.

The light control layer AR may include about 0.01 wt% to about 5.00 wt% of the first colorant with respect to a total weight of the light control layer AR. When the light control layer AR includes less than about 0.01 wt% of the first colorant, light in a specific wavelength range may not be sufficiently absorbed, and color gamut may thus not be improved. When the light control layer AR includes more than about 5.00 wt% of the first colorant, cohesion of the first colorant may occur.

In an embodiment, the display device DD may further include light-shielding portions BM which are disposed on the display element layer DP-ED, covered by the light control layer AR, and overlap the light-shielding region NPXA. The light-shielding portions BM may be disposed to be spaced apart from each other. The light-shielding portions BM may prevent a light leakage phenomenon. The light-shielding portions BM may be light-shielding members. The light-shielding portions BM may include an organic light-shielding material, a black dye, a black pigment, or the like. The light control layer AR may fill a gap between the light-shielding portions BM spaced apart from each other.

The sensor layer TU is disposed between the display panel DP and the light control layer AR. The sensor layer TU may include a sensor base layer BS-TU, a first conductive layer SP1, an inorganic insulating layer IL, a second conductive layer SP2, and an organic insulating layer OL. The first conductive layer SP1 may be disposed on the sensor base layer BS-TU. The inorganic insulating layer IL may cover the first conductive layer SP1 and may be disposed on the sensor base layer BS-TU and the first conductive layer SP1. The second conductive layer SP2 may be disposed on the inorganic insulating layer IL. The organic insulating layer OL may cover the second conductive layer SP2 and may be disposed on the inorganic insulating layer IL and the second conductive layer SP2.

The sensor base layer BS-TU may be an inorganic layer including any one of silicon nitride, silicon oxynitride, or silicon oxide. Alternatively, the sensor base layer BS-TU may be an organic layer including an epoxy resin, an acryl resin, or an imide-based resin. The sensor base layer BS-TU may have a single-layered structure or a multi-layered structure in which layers are stacked along a third direction DR3. The sensor base layer BS-TU may be directly disposed on the encapsulation layer TFE.

Each of the first conductive layer SP1 and the second conductive layer SP2 may have a single-layered structure or a multi-layered structure in which layers are stacked along the third direction DR3. The conductive layers SP1 and SP2 each having a single-layered structure may include a metal layer or a transparent conductive layer. The metal layer may include molybdenum, silver, titanium, copper, aluminium, or alloys thereof. The transparent conductive layer may include a transparent conductive oxide such as indium tin oxide (ITO), indium zinc oxide (IZO), zinc oxide (ZnO), and indium zinc tin oxide (IZTO). In addition, the transparent conductive layer may include a conductive polymer such as PEDOT, a metal nanowire, graphene, etc.

The conductive layers SP1 and SP2 each having a multi-layered structure may include metal layers. The metal layers may have a three-layered structure of titanium (Ti)/aluminium (Al)/titanium (Ti) for example. The conductive layers SP1 and SP2 each having a multi-layered structure may include at least one metal layer and at least one transparent conductive layer.

The inorganic insulating layer IL may include at least one of aluminium oxide, titanium oxide, silicon oxide, silicon oxynitride, zirconium oxide, and hafnium oxide. A contact hole CN may be defined in the inorganic insulating layer IL. The first conductive layer SP1 and the second conductive layer SP2 may be electrically connected through the contact hole CN. The contact hole CN may be filled with a material of the second conductive layer SP2. FIG. 4 illustrates that a single contact hole CN is defined in the inorganic insulating layer IL, but an embodiment of the inventive concept is not limited thereto, and a plurality of contact holes may be defined in the inorganic insulating layer.

The organic insulating layer OL may cover the inorganic insulating layer IL and the second conductive layer SP2. The organic insulating layer OL may include at least one of an acrylate-based resin, a methacrylate-based resin, a polyisoprene-based resin, a vinyl-based resin, an epoxy-based resin, a urethane-based resin, a cellulose-based resin, a siloxane-based resin, a polyimide-based resin, a polyamide-based resin, and a perylene-based resin.

FIG. 5 is an enlarged cross-sectional view of a portion of a display device according to an embodiment of the inventive concept. FIG. 5 illustrates an enlarged cross section corresponding to an AA region of FIG. 4 so as to more specifically illustrate a shape in which the inorganic deposition layer INF is disposed on the light-emitting element ED. The inorganic deposition layer INF of the inventive concept will be more specifically described below with reference to FIG. 5. Meanwhile, the same component as the component described above will be denoted as the same numerals or symbols, and detailed description thereof will be omitted.

The inorganic deposition layer INF may include a first portion P1 and a second portion P2. The first portion P1 may be defined as a portion including a first upper surface US1, and the second portion P2 may be defined as a portion including a second upper surface US2. In the inorganic deposition layer INF, each of the first upper surface US1 and the second upper surface US2 may refer to a surface in contact with the encapsulation layer TFE. Meanwhile, as used herein, the first portion P1 may be referred to as a "partition portion", and the second portion P2 may be referred to as a "flat portion".

The first upper surface US1 of the first portion P1 may refer to a flat surface inclined at a first angle θ1 with respect to an upper surface B_US of the base substrate BS. The first angle θ1 may refer to an angle formed by the first upper surface US1 and the upper surface B_US of the base substrate BS. The first angle θ1 may be about 60 degrees to about 90 degrees. For example, the first angle θ1 may be about 65 degrees to about 85 degrees. A normal direction of the first upper surface US1 may not be parallel to a third direction DR3.

The first portion P1 may correspond to a side surface SS of the pixel-defining film PDL. The first portion P1 may be a portion disposed on some of the light-emitting elements ED disposed along the side surface SS of the pixel-defining film PDL. The side surface SS of the pixel-defining film PDL may refer to a surface defining the pixel opening OH (see FIG. 4). The first upper surface US1 of the first portion P1 may be substantially parallel to the side surface SS of the pixel-defining film PDL. The first angle θ1 formed by the upper surface B_US of the base substrate BS and the first upper surface US1 may be substantially the same as a second angle θ2 formed by the upper surface B_US of the base substrate BS and the side surface SS of the pixel-defining film PDL. Meanwhile, as used herein, the wording, "substantially parallel" includes not only a case in which two surfaces do not meet each other no matter how long the surfaces extend, but also a case in which, despite two surfaces designed to be parallel to each other, there is a difference in distance between the two surfaces which falls within a margin of error in a process. The wording, "substantially the same" includes not only a case in which components have physically completely the same thickness, etc., but also a case in which, despite the same design of components, there is a difference in thickness, etc., therebetween which falls within a margin of error in a process.

The second upper surface US2 may be substantially parallel to the upper surface B_US of the base substrate BS. Each of the second upper surface US2 and the upper surface B_US of the base substrate BS may be parallel to a plane defined by a first direction DR1 and a second direction DR2 crossing each other. Accordingly, a normal direction of each of the second upper surface US2 and the upper surface B_US of the base substrate BS may be parallel to the third direction DR3.

A first thickness d1 of the first portion P1 may be greater than a second thickness d2 of the second portion P2. The first thickness d1 may refer to a shortest distance between the first upper surface US1 and the light-emitting element ED. For example, the first thickness d1 may refer to a perpendicular distance from an upper surface of the capping layer CPL in the light-emitting element ED to the first upper surface US1. As used herein, the term "perpendicular distance" may refer to a shortest distance as measured along a normal direction that is perpendicular to a tangent line at a measuring point. The second thickness d2 may refer to a shortest distance between the second upper surface US2 and the light-emitting element ED. For example, the second thickness d2 may refer to a distance from an upper surface of the capping layer CPL in the light-emitting element ED to the second upper surface US2 in the third direction DR3. A difference between the first thickness d1 and the second thickness d2 may be about 5 Å to about 50 Å. For example, the first thickness d1 may be about 50 Å to about 200 Å, and the second thickness d2 may be about 40 Å or more and less than about 100 Å. When the first thickness d1 of the first portion P1 is less than about 50 Å, layer uniformity of the inorganic deposition layer INF including the first portion P1 may be reduced. In an embodiment, when the first portion P1 is composed of a bismuth (Bi) material, the first thickness d1 may be desirably about 100 Å. When the first portion P1 is composed of bismuth (Bi) and the first thickness d1 is about 100 Å, layer uniformity of the inorganic deposition layer INF including the first portion P1 may be secured. In an embodiment, when the first portion P1 includes a YbₓBi_{y}-mixed deposition material, the first thickness d1 may be desirably about 50 Å to about 70 Å.

When the first portion P1 is composed of a YbₓBi_{y}-mixed deposition material and the first thickness d1 is about 50 Å to about 70 Å, layer uniformity of the inorganic deposition layer INF including the first portion P1 may be secured. When the second thickness d2 of the second portion P2 is more than about 100 Å, an external light reflectance of the display device DD (see FIG. 4) including the second portion P2 may increase, and light emission efficiency may be reduced.

A surface roughness of the first upper surface US1 of the first portion P1 may be lower than a surface roughness of the second upper surface US2 of the second portion P2. The second upper surface US2 may include an irregular pattern PT, and the first upper surface US1 may not include the irregular pattern PT. The irregular pattern PT may be formed by etching at least a portion of the second portion P2 through an etching process.

According to an embodiment of the inventive concept, a display device includes, in an inorganic deposition layer, a portion having a non-uniform thickness. In the inorganic deposition layer, a flat portion arranged in parallel to a base substrate, etc., has a relatively thin structure, and a partition portion having a specific inclination due to an opening in which a pixel is defined has a relatively thick structure. Accordingly, a display device according to an embodiment of the inventive concept may have an improved light efficiency and reduced external light reflection. More specifically, since the flat portion is relatively thin in the inorganic deposition layer, external light reflection may be reduced, and effectiveness of light transmittance may be improved. In addition, since the partition portion is relatively thick in the inorganic deposition layer, layer uniformity may be secured, and light emission efficiency may increase. Accordingly, a display device may have improved reliability and an increased manufacturing efficiency. In addition, since the flat portion may have a relatively high surface roughness, compared to the partition portion, due to having an irregular pattern, a display device having a reduced white angular dependency (WAD) property may be provided. Therefore, a display device according to an embodiment of the inventive concept may include the inorganic deposition layer including the flat portion and the partition portion, and may thus have improved reliability due to an improved light emitting property.

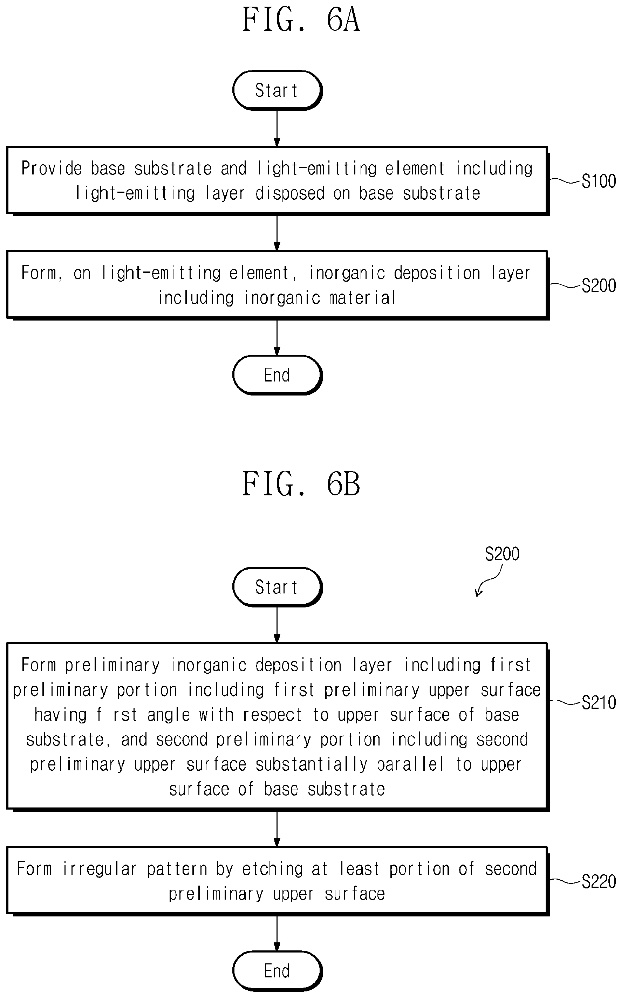

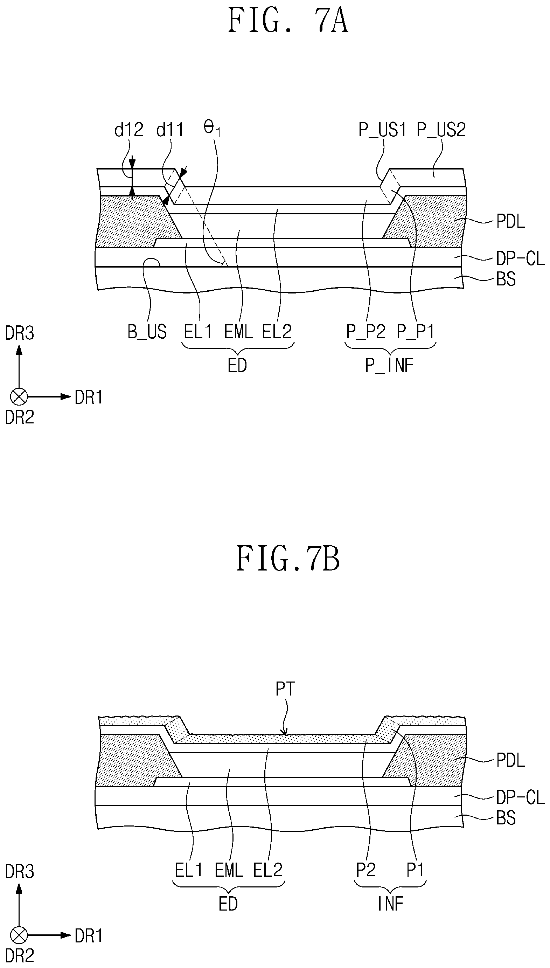

A method of manufacturing a display device according to an embodiment of the inventive concept will be described below with reference to FIG. 6A, FIG. 6B, FIG. 7A, and FIG. 7B.

FIG. 6A is a flowchart illustrating a method of manufacturing a display device according to an embodiment of the inventive concept. FIG. 6B is a flowchart specifically illustrating forming an inorganic deposition layer in a method of manufacturing a display device according to an embodiment of the inventive concept. FIG. 7A and FIG. 7B are drawings sequentially illustrating some operations in a method of manufacturing a display device according to an embodiment of the inventive concept. Meanwhile, in description of a method of manufacturing a display device according to an embodiment of the inventive concept, the same component as the component described above will be denoted as the same numerals or symbols, and detailed description thereof will be omitted.

Referring to FIG. 6A and FIG. 7A, a method of manufacturing a display device according to an embodiment of the inventive concept may include providing a base substrate BS and a light-emitting element ED including a light-emitting layer EML disposed on the base substrate BS (S100).

Referring to FIG. 6A and FIG. 7B, the method of manufacturing a display device according to an embodiment of the inventive concept may include, after the providing of the light-emitting element ED (S100), forming an inorganic deposition layer INF on the light-emitting element ED (S200).

Referring to FIG. 6B and FIG. 7B, the forming of the inorganic deposition layer INF (S200) may include forming a preliminary inorganic deposition layer P_INF including a first preliminary portion P_P1 and a second preliminary portion P_P2 (S210) and then forming an irregular pattern PT by etching at least a portion of a second preliminary upper surface P_US2 (S220).

Referring to FIG. 7A and FIG. 7B, in the forming of the preliminary inorganic deposition layer P_INF, the preliminary inorganic deposition layer P_INF may include the first preliminary portion P_P1 including a first preliminary upper surface P_US1 and the second preliminary portion P_P2 including the second preliminary upper surface P_US2. The first preliminary upper surface P_US1 may refer to a surface having a first angle θ1 with respect to an upper surface B_US of the base substrate BS, and the second preliminary upper surface P_US2 may refer to a surface substantially parallel to the upper surface of the base substrate BS. The first angle θ1 may be about 60 degrees to about 90 degrees, and the first preliminary upper surface P_US1 having the first angle θ1 may refer to a surface inclined with respect to the upper surface B_US of the base substrate BS. The first preliminary portion P_P1 including the first preliminary upper surface P_US1 may be a portion formed along a side surface of a pixel-defining film PDL.

In the forming of the preliminary inorganic deposition layer P_INF, the first preliminary portion P_P1 and the second preliminary portion P_P2 may be formed of the same material through the same process. Accordingly, a thickness d11 of the first preliminary portion P_P1 and a thickness d12 of the second preliminary portion P_P2 may be substantially the same. The thickness d11 of the first preliminary portion P_P1 and the thickness d12 of the second preliminary portion P_P2 may be about 50 Å to about 200 Å.

The forming of the preliminary inorganic deposition layer P_INF may include a process of depositing an inorganic material having a refractive index of about 1.0 or more and a light absorption coefficient of about 0.5 or more. The forming of the preliminary inorganic deposition layer P_INF may include a process of depositing an inorganic material having a melting point of about 1000°C or less. The preliminary inorganic deposition layer P_INF may be deposited to entirely overlap the light-emitting element ED. The forming of the preliminary inorganic deposition layer P_INF may include performing a thermal evaporation process. The forming of the preliminary inorganic deposition layer P_INF may be constituted of a thermal evaporation process.

The forming of the irregular pattern PT may include etching at least a portion of the second preliminary portion P_P2. The forming of the irregular pattern PT may include etching at least a portion of the second preliminary upper surface P_US2. The etching of at least a portion of the second preliminary upper surface P_US2 may include performing any one among a wet etching process, a dry etching process, an ion milling process, and a spacer patterning technology (SPT) process.

The forming of the irregular pattern PT may include forming a second portion P2 by etching at least a portion of the second preliminary upper surface P_US2. Since at least a portion of the second preliminary upper surface P_US2 may be etched, a thickness of the second portion P2 may be about 40 Å or more and less than 100 Å. Particles (not illustrated) of the second preliminary portion P_P2 may be generated during the etching of the second preliminary upper surface P_US2. The generated particles (not illustrated) may arrive at the first preliminary upper surface P_US1. The particles (not illustrated) may be attached onto the first preliminary upper surface P_US1 of the first preliminary portion P_P1, and thus a first portion P1 may be formed. Accordingly, the first portion P1 onto which the particles (not illustrated) are additionally attached may have a greater thickness value than the first preliminary portion P_P1. Since the etching of at least a portion of the second preliminary upper surface P_US2 may be included, a thickness of the first portion P1 may become greater than a thickness of the first preliminary portion P_P1, and a thickness of the second portion P2 may become smaller than a thickness of the second preliminary portion P_P2. Accordingly, a thickness of the first portion P1 may be greater than a thickness of the second portion P2.

The forming of the irregular pattern PT may include the etching of the second preliminary upper surface P_US2 and may not include etching the first preliminary upper surface P_US1. The irregular pattern PT may be formed only on an upper surface of the second portion P2 and may not be formed on an upper surface of the first portion P1. Accordingly, a surface roughness of the upper surface of the second portion P2 may be higher than a surface roughness of the upper surface of the first portion P1.

Although the embodiments of the inventive concept have been described, it is understood that the inventive concept should not be limited to these embodiments but various changes and modifications can be made by a person skill in the art within the spirit and scope of the inventive concept as hereinafter claimed. Therefore, the technical scope of the inventive concept is not limited to the contents described in the detailed description of the specification, but should be defined by the accompanying claims.

### [Industrial Applicability]

Recent display devices have excellent optical characteristics by including an optical functional layer on a display panel. Meanwhile, when the optical functional layer, especially an inorganic deposition layer for preventing external light reflection, is included, the optical characteristics or film uniformity may decrease depending on the thickness of the inorganic layer, and thus the display efficiency of the display device may be reduced. According to an embodiment of the present invention, a display device includes a portion having different thicknesses within an inorganic deposition layer, thereby improving the display efficiency by ensuring film uniformity while having external light reflection reduction characteristics, and thus improving the optical characteristics. Therefore, the present invention, which provides a display device according to an embodiment, has high industrial applicability.

## Claims

1. A display device comprising a display panel, the display panel including:
a base substrate;
a light-emitting element disposed on the base substrate and including a light-emitting layer;
an inorganic deposition layer disposed on the light-emitting element; and
an encapsulation layer disposed on the inorganic deposition layer,
wherein the inorganic deposition layer includes a first portion including a first upper surface having a first angle with respect to an upper surface of the base substrate, and a second portion including a second upper surface substantially parallel to the upper surface of the base substrate, and
a first thickness of the first portion is greater than a second thickness of the second portion.

2. The display device of claim 1, wherein the first angle is about 60 degrees to about 90 degrees.

3. The display device of claim 1, wherein a surface roughness of the first upper surface is lower than a surface roughness of the second upper surface.

4. The display device of claim 1, wherein an irregular pattern is defined on the second upper surface.

5. The display device of claim 1, wherein the display panel further comprises a pixel-defining film disposed on the base substrate and having an opening defined therein, and
the light-emitting layer is disposed in the opening.

6. The display device of claim 5, wherein the pixel-defining film comprises a side surface defining the opening, and
a second angle formed by the side surface of the pixel-defining film with respect to the upper surface of the base substrate is substantially the same as the first angle.

7. The display device of claim 1, wherein the inorganic deposition layer comprises an inorganic material having a refractive index of about 1.0 or more and a light absorption coefficient of about 0.5 or more.

8. The display device of claim 1, wherein the inorganic deposition layer comprises at least one selected from the group consisting of bismuth (Bi) and ytterbium (Yb).

9. The display device of claim 1, wherein a difference between the first thickness and the second thickness is about 5 Å to about 50 Å.

10. The display device of claim 1, wherein the first thickness is about 50 Å to about 200 Å.

11. The display device of claim 1, wherein the second thickness is about 40 Å or more and less than about 100 Å.

12. The display device of claim 1, wherein the encapsulation layer is entirely in contact with the first upper surface and the second upper surface.

13. The display device of claim 1, wherein the light-emitting element further comprises:
a first electrode disposed on the base substrate;
a second electrode disposed to be spaced apart from the first electrode with the light-emitting layer therebetween;
a hole transport region disposed between the first electrode and the light-emitting layer;
an electron transport region disposed between the second electrode and the light-emitting layer; and
a capping layer disposed on the second electrode,
the inorganic deposition layer being directly disposed on the capping layer.

14. The display device of claim 1, further comprising:
a light control layer disposed on the display panel and including a dye or a pigment; and
a sensor layer disposed between the display panel and the light control layer.

15. A display device, comprising:
a display panel; and
a light control layer disposed on the display panel and including a dye or a pigment,
wherein the display panel includes
a base substrate,
a light-emitting element disposed on the base substrate and including a light-emitting layer,
an inorganic deposition layer disposed on the light-emitting element, and including a partition portion and a flat portion adjacent to the partition portion, and
an encapsulation layer being entirely in contact with a first upper surface of the partition portion and a second upper surface of the flat portion,
the first upper surface has a first angle with respect to an upper surface of the base substrate, the second upper surface is substantially parallel to the upper surface of the base substrate, and
a surface roughness of the first upper surface is lower than a surface roughness of the second upper surface.

16. A method of manufacturing a display device, the method comprising:
providing a base substrate and a light-emitting element including a light-emitting layer disposed on the base substrate;
forming, on the light-emitting element, an inorganic deposition layer including an inorganic material; and
forming an encapsulation layer on the inorganic deposition layer,
wherein the forming of the inorganic deposition layer includes
forming a preliminary inorganic deposition layer including a first preliminary portion which includes a first preliminary upper surface having a first angle with respect to an upper surface of the base substrate, and a second preliminary portion which includes a second preliminary upper surface substantially parallel to the upper surface of the base substrate, and
forming an irregular pattern by etching at least a portion of the second preliminary upper surface.

17. The method of claim 16, wherein the first angle is about 60 degrees to about 90 degrees.

18. The method of claim 16, wherein the forming of the preliminary inorganic deposition layer comprises performing a thermal evaporation process.

19. The method of claim 16, wherein the forming of the irregular pattern comprises performing any one among a wet etching process, a dry etching process, and an ion milling process.

20. The method of claim 16, wherein a thickness of the first preliminary portion and a thickness of the second preliminary portion are substantially the same.
